# EUROPEAN PATENT SPECIFICATION

(11) **EP 2 309 551 B1**
(45) Date of publication and mention of the grant of the patent: **13.08.2014**
(21) Application number: 09770159.3
(22) Date of filing: 23.06.2009
(51) Int. Cl.: H01L 31/042, B32B 27/30

(54) **BACKSHEET FOR SOLAR CELL MODULE AND SOLAR CELL MODULE**
RÜCKSEITENBLATT BZW. BACKSHEET FÜR EIN SOLARZELLENMODUL UND SOLARZELLENMODUL
FEUILLE ARRIERE POUR MODULE DE CELLULE SOLAIRE ET MODULE DE CELLULE SOLAIRE

(30) Priority: 23.06.2008 JP 2008163788
(43) Date of publication of application: 13.04.2011
(73) Proprietor: Asahi Glass Company, Limited, Chiyoda-ku Tokyo 100-8405 (JP)
(72) Inventor: TAKAYANAGI, Takashi, Tokyo 100-8405 (JP); MASUDA, Sho, Tokyo 100-8405 (JP); SUMI, Naoko, Tokyo 100-8405 (JP)
(74) Representative: Müller-Boré & Partner Patentanwälte PartG mbB
(86) International application number: PCT/JP2009/061418
(87) International publication number: WO 2009/157449

(56) References cited:
- WO-A1-2007/010706
- WO-A1-2007/063698
- WO-A1-2007/063698
- WO-A1-2007/072826
- WO-A1-2007/072826
- WO-A1-2008/047761
- WO-A1-2008/047761
- WO-A1-2009/097024
- WO-A2-2008/143719
- JP-A- 3 122 152
- JP-A- 3 122 152
- JP-A- 2003 062 921
- JP-A- 2003 062 921
- JP-A- 2004 307 666
- JP-A- 2004 307 666

## Description

The present invention relates to a backsheet for a solar cell module, and a solar cell module having the backsheet.

A solar cell module is composed of a surface layer, a sealing material layer which seals a solar cell, and a backsheet. As a sealing material to constitute a sealing material layer, an ethylene/vinyl acetate copolymer (hereinafter referred to as EVA) is commonly used.

The backsheet is required to have various characteristics such as mechanical strength, weatherability, water/moisture-proof property and electrical insulation property. A common backsheet has a multilayer structure, and is, for example, composed of, sequentially from the side in contact with the sealing material layer of a solar cell, an electrical insulation layer, a water/moisture-proof layer and a rear surface layer which is located at the rear side of the solar cell.

Usually, a film of polyvinyl fluoride is used for the electrical insulation layer and the rear surface layer for the reason of e.g. excellent weatherability, water/moisture-proof property and electrical insulation property, and a PET film is used for a substrate sheet. Further, in the case where a backsheet is required to have a high water/moisture-proof effect, a vapor-deposited layer of a metal oxide such as silica or a metal layer such as an aluminum foil is provided on the substrate sheet.

The thickness of the backsheet is commonly adjusted to be from 20 to 100 µm so that the above required properties and other required properties such as durability and light blocking property are satisfied. However, in recent years, the backsheet is required to be made lighter and thinner.

The present inventors considered that the film of polyvinyl fluoride used for the electric insulating layer and the rear surface layer of the backsheet had a disadvantage in making the backsheet lighter and thinner because such a film needs to be adhered to a film of polyethylene terephthalate (an ethylene glycol/terephthalic acid copolymer, hereinafter referred to as PET) and further to have an adhesion layer. Further, there was a problem that the production process was complicated.

A backsheet of a solar cell module wherein a cured coating film of a curable functional group-containing fluoropolymer coating material is formed on at least one surface of a water-impermeable sheet, is proposed (Patent Document 1). This document discloses a curable tetrafluoroethylen (TFE) copolymer (ZEFFLE GK-570) as the curable functional group-containing fluoropolymer. However, it was found that the cured coating film of the curable functional group-containing fluoropolymer is insufficient in flexibility of the coating film, adhesion to a substrate and folding endurance property, and therefore problems such as cracking, fracturing, whitening and separation occur, and that it has low dispersibility of a pigment or a curing agent, and therefore there are problems such as ununiformity in color due to poor in dispersibility and insufficient curing due to poor in dispersibility of the curing agent.

Patent Document 1: JP-A-2007-035694

WO 2008/143719 A2, which is prior art according to Art. 54(3) EPC, discloses a backing sheet for a photovoltaic module comprising a layer comprising an organic solvent soluble and/or water dispersible, crosslinkable amorphous fluoropolymers. WO 2009/097024 A1, which is prior art according to Art. 54(3) EPC, discloses a backing sheet for a photovoltaic module comprising a substrate; and a layer comprising fluoropolymer cured on the substrate, wherein the layer comprising fluoropolymer includes a hydrophobic silica.

WO 2007/010706 A1 discloses a backsheet of a solar cell module having, at least on either surface of a water-impermeable sheet, a cured coating film of a coating material comprising a fluorine-containing polymer having curable functional group.

WO 2007/072826 A1 discloses a fluorine-containing copolymer solution containing a fluorine-containing copolymer and a weak solvent, which is characterized by containing 73 to 90% by mass of the fluorine-containing copolymer which is a copolymer of a fluoroolefin having two or more fluorine atoms and a double bond-containing monomer which is copolymerizable with the fluoroolefin, wherein 10 to 30 mol% of the double bond-containing monomer has a hydroxyl group while 20 to 80 mol% thereof has a branched alkyl group having three or more carbon atoms.

WO 2008/047761 A1 discloses a fluorine coating composition comprising (A) a base component comprising a copolymer of a fluoroolefin and a double bond-containing monomer copolymerizable with the fluoroolefin, wherein the copolymer has a fluorine content of 10% by mass or more based on the fluoroolefin, 5 to 30% by mol of the double bond-containing monomer has a hydroxyl group, and 10 to 50% by mol of the double bond-containing monomer has a branched alkyl group having 3 or more carbon atoms, and (B) a curing agent comprising a polyisocyanate compound, wherein the polyisocyanate is produced by the reaction of at least one diisocyanate selected from an aliphatic diisocyanate and an alicyclic diisocyanate with a monoalcohol having 1 to 20 carbon atoms and has a molar ratio of an allophanate group to an isocyanurate group in the range from 90:10 to 81:19.

JP 2004-307666 A discloses a fluorine-containing copolymer for coatings which is soluble in a weak solvent, and which has a crosslinkable functional group and has a mass average molecular weight between crosslinking points of 1.300 or less. JP 3-122152 A discloses a room temperature curing composition or sealant obtained by blending a specific fluorine-containing copolymer containing polymer units having polyether side chains and polymer units based on a fluoroolefin, with a specific copolymer having functional groups co-crosslinkeable with the specific fluorine-containing copolymer and polyfluoroalkyl groups, and a filler.

WO 2007/063698 A1 discloses a coating composition for a protection cover of solar cell, which comprises a curable fluorine-containing coating composition comprising a curable fluorine-containing resin, a curing agent and a solvent and being used for forming a top coat layer of a cured fluorine-containing resin, said top coat layer being provided, directly or via a primer layer, on a transparent resin layer provided on the sunlight irradiation side of a solar cell module.

JP 2003-062921 A discloses a transparent composite film comprising an organic polymer film layer, a transparent adhesive layer provided on one surface thereof and a hard coat layer comprising a cured film of a curable resin provided on the other surface thereof and a moisture-proof layer provided between the organic polymer film and the transparent adhesive layer and/or between the organic polymer film and the hard coat layer.

The present invention is to provide a lightweight and highly productive backsheet for a solar cell module wherein a cured coating film layer of a specific fluoropolymer coating material is provided on one side or each side of a substrate sheet, whereby the cured coating film layer has excellent flexibility and adhesion to the substrate and is free from problems such as cracking, fracturing, whitening and separation.

As a result of an extensive study, the present inventors have found that a cured coating film layer of a coating material containing a specific fluoropolymer (A) as an essential component, provided on one side or each side of a substrate sheet, is especially excellent in flexibility of the coating film layer and adhesion to the substrate, and have accomplished the present invention.

That is, the present invention is the following [1] to [11]:
[1] A backsheet for a solar cell module, comprising a substrate sheet and a cured coating film layer of a coating material formed on one side or each side of the substrate sheet, said coating material is an aqueous dispersion coating material comprising water and a fluoropolymer (A) obtained by solution polymerization dispersed in water, said fluoropolymer (A) having repeating units based on a fluoroolefin (a), repeating units based on a crosslinkable group-containing monomer (b) having a hydroxy group as the crosslinkable group, and repeating units based on an alkyl group-containing monomer (c) wherein a C₂₋₂₀ linear or branched alkyl group having no quaternary carbon atom, and a polymerizable unsaturated group are linked to each other by an ether bond or ester bond, wherein the fluoropolymer (A) is a fluoropolymer having carboxy groups and of which some or all of the carboxy groups constitute salts with a basic substance.
[2] The backsheet for a solar cell module according to [1], wherein the total content of the repeating units based on the alkyl group-containing monomer (c) in the all repeating units in the fluoropolymer (A) is from 10 to 50 mol%.
[3] The backsheet for a solar cell module according to [1] or [2], wherein the crosslinkable group of the crosslinkable group-containing monomer (b) is a hydroxy group, and the fluoropolymer (A) has a hydroxy value of from 30 to 200 mgKOH/g.
[4] The backsheet for a solar cell module according to any one of [1] to [3], wherein the coating material is an aqueous dispersion coating material, wherein the fluoropolymer (A) having a hydroxy group at the terminal as a crosslinkable group and a side chain having a polyoxyethylene structure, is dispersed in water.
[5] The backsheet for a solar cell module according to any one of [1] to [4], wherein the coating material contains an ultraviolet absorbing agent:
[6] The backsheet for a solar cell module according to any one of [1] to [5], wherein the coating material contains a pigment.
[7] The backsheet for a solar cell module according to [6], wherein the pigment is titanium oxide or the following composite particles:
   Composite particles: Particles comprising particles containing titanium oxide, a covering layer covering the above particles and made of a layer containing cerium oxide, and a covering layer covering the above coating film layer and made of a layer containing silicon oxide.
[8] The backsheet for a solar cell module according to any one of [1] to [7], wherein a layer of a polymer material different from the above cured coating film layer is provided on the outermost surface of the backsheet at the side in contact with the solar cell.
[9] A solar cell module having a surface sheet, a sealing layer in which a solar cell is sealed with a resin and the backsheet for a solar cell module as defined in any one of [1] to [8], laminated in this order.
[10] A process for producing a backsheet for a solar cell module, comprising acid-modifying, with an acid anhydride, some or all of the hydroxy groups of a fluoropolymer having repeating units based on a fluoroolefin (a), repeating units based on a crosslinkable group-containing monomer (b) having a hydroxy group as the crosslinkable group and repeating units based on an alkyl group-containing monomer (c) wherein a C₂₋₂₀ linear or branched alkyl group having no quaternary carbon atom, and a polymerizable unsaturated group are linked to each other by an ether bond or ester bond; neutralizing it with a base substance to obtain a fluoropolymer (A) obtained by solution polymerization; and applying an aqueous dispersion coating material comprising the fluoropolymer (A), water and a curing agent, to one side or each side of a substrate sheet, followed by drying and curing to form a cured coating film layer.
[11] The production process according to [10], wherein the curing agent is an aqueous dispersible isocyanate curing agent.

According to the present invention, a cured coating film layer of a specific fluoropolymer coating material is provided on one side or each side of a substrate, whereby it is possible to obtain a lightweight and highly productive backsheet for a solar cell module, which is especially excellent in flexibility of the coating film layer and adhesion to the substrate and is free from problems such as cracking, fracturing, whitening and separation. Further, it is possible to obtain a solar cell module provided with such a backsheet.
Fig. 1 is a cross-sectional view of an embodiment of the solar cell module of the present invention.
Fig. 2 is a cross-sectional view of an embodiment of the solar cell module of the present invention, wherein a metal layer is provided.
Fig. 3 is a cross-sectional view of an embodiment of the solar cell module of the present invention, wherein a EVA layer is provided.

In this description, repeating units which are directly obtained by polymerization and repeating units which are obtained by further reacting the repeating units directly obtained by polymerization are collectively referred to as "units".

The backsheet for a solar cell module of the present invention (hereinafter sometimes simply referred to as "a backsheet") is characterized in that a cured coating film layer (hereinafter sometimes simply referred to as "a coating film layer") of a coating material (hereinafter sometimes simply referred to as "a coating material") containing a fluoropolymer (A) is formed on one side or each side of a substrate sheet.

### [Fluoropolymer (A)]

Fluoropolymer (A) comprises units based on a fluoroolefin (a), units based on a crosslinkable group-containing monomer (b) and units based on an alkyl group-containing monomer (c) wherein a C₂₋₂₀ linear or branched alkyl group having no quaternary carbon atom, and a polymerizable unsaturated group are linked to each other by an ether bond or ester bond.

### <Fluoroolefin (a)>

The fluoroolefin (a) may, for example, be chlorotrifluoroethylene (hereinafter referred to as "CTFE"), tetrafluoroethylene (hereinafter referred to as "TFE"), hexafluoropropylene, vinyl fluoride or vinylidene fluoride. Among them, CTFE or TFE is preferred from the viewpoint of weatherability and solvent resistance of the coating film, and CTFE is most preferred from the viewpoint of dispersibility of a curing agent, dispersibility of a pigment and adhesion.

One type of the fluoroolefin (a) may be singly used, or two or more types may be used in combination.

As the proportion of the units based on a fluoroolefin (a) in a fluoropolymer (A) becomes larger, weatherability of the coating film layer will be improved, and as it becomes smaller, the solvent solubility will be improved. The proportion of the units based on a fluoroolefin (a) in the all units in a fluoropolymer (A) is preferably from 30 to 70 mol%, more preferably from 40 to 60 mol%.

### <Crosslinkable group-containing monomer (b)>

In order to form a cured coating film on a substrate sheet, it is preferred that a coating material containing, as an essential component ,a fluoropolymer (A) to which a curing agent is added is applied to a substrate sheet. In this case, the crosslinkable group in the units based on a crosslinkable group-containing monomer (b) undergoes crosslinking reaction with a curing agent to cure the coating film layer. Further, with some types of the crosslinking group, the coating film layer is cured merely by drying, and in this case, it is not necessary to add a curing agent to the coating material. The coating film layer is cured, whereby hardness, mechanical strength, water/moisture-proof property, solvent resistance and so on are imparted to the coating film layer.

The crosslinkable group-containing monomer (b) is a monomer having a crosslinkable group as well as having a polymerizable unsaturated group. The crosslinkable group-containing monomer (b) is preferably a monomer having no quaternary carbon atom or ring structure.

The crosslinkable group is a hydroxy group, from the viewpoint of crosslinking reactivity, availability and easiness of introduction into polymers.

The polymerizable unsaturated group is preferably a group having an ethylenic unsaturated double bond, and preferably a vinyl group, an allyl group or a 1-propenyl group.

The crosslinkable-containing monomer (b) having a hydroxy group as the crosslinkable group is preferably a monomer wherein a C₂₋₂₀ linear or branched alkyl group having a hydroxy group and the above polymerizable unsaturated group are linked to each other by an ether bond or ester bond. Further, in order to obtain an aqueous dispersible polymer, which will be described later, a hydroxy group-containing monomer having a hydrophilic block such as a polyoxyethylene chain may also be used.

The crosslinkable group-containing monomer (b) having a hydroxy group is preferably a hydroxyalkyl vinyl ether such as 2-hydroxyethyl vinyl ether, 3-hydroxypropyl vinyl ether, 2-hydroxypropyl vinyl ether, 2-hydroxy-2-methylpropyl vinyl ether, 4-hydroxybutyl vinyl ether, 4-hydroxy-2-methylbutyl vinyl ether, 5-hydroxypentyl vinyl ether or 6-hydroxyhexyl vinyl ether; a monovinyl ether of an alicyclic diol such as cyclohexanedimethanol monovinyl ether; a polyethylene glycol monovinyl ether such as diethylene glycol monovinyl ether, triethylene glycol monovinyl ether or tetraethylene glycol monovinyl ether; a hydroxyalkyl allyl ether such as hydroxyethyl allyl ether, hydroxybutyl allyl ether, 2-hydroxyethyl allyl ether, 4-hydroxybutyl allyl ether or glycerol monoallyl ether; a hydroxyalkyl vinyl ester such as hydroxyethyl vinyl ester or hydroxybutyl vinyl ester; a hydroxyalkyl allyl ester such as hydroxyethyl allyl ester or hydroxybutyl allyl ester; or a (meth)acrylic acid hydroxyalkyl ester such as hydroxyethyl (meth)acrylate.

One of hydroxy group containing-monomers having a polyoxyethylene chain other than a polyethylene glycol monovinyl ether may be a compound obtained by ring-opening addition of ethylene oxide to a hydroxy group of the above hydroxy group-containing compound. For example, a compound having a polyoxyethylene chain having a hydroxy group at the terminal can be obtained by ring-opening addition of ethylene oxide to 4-hydroxybutyl vinyl ether or cyclohexanedimethanol monovinyl ether.

The crosslinkable group-containing monomer (b) having a hydroxy group is preferably a hydroxyalkyl vinyl ether, an ethylene glycol monovinyl ether or a hydroxyalkyl allyl ether, particularly preferably 2-hydroxyethyl vinyl ether, 4-hydroxybutyl vinyl ether, diethylene glycol monovinyl ether, hydroxybutyl allyl ether or 2-hydroxyethyl allyl ether, because they are excellent in alternating polymerizability and good in weatherability of a coating film layer to be formed.

As to the crosslinkable group-containing monomer (b), one type of such a monomer may be singly used, or two or more types of such monomers having different crosslinkable groups or monomers having the same crosslinkable group but having different structures, may be used in combination.

The amount of the crosslinkable groups contained in the fluoropolymer (A) has an influence on mechanical properties of the cured coating film layer. If the content of the crosslinkable groups is small, the curing will be insufficient, and the mechanical properties of the cured coating film layer will be deteriorated. On the other hand, if the content of the crosslinkable groups is large, the cured coating film layer will be too hard, and the flexibility will be decreased. Therefore, the content of the crosslinkable groups is preferably within a specific range from the viewpoint of crosslinking density.

For example, the content of the units based on the hydroxy group-containing monomer in the all units in the fluoropolymer (A) is preferably an amount such that the hydroxy value of the fluoropolymer (A) becomes from 30 to 200 mgKOH/g, more preferably from 40 to 150 mgKOH/g.

Further, a hydroxy group-containing monomer having a polyoxyethylene chain is used, whereby the fluoropolymer (A) becomes likely to be dispersed in water.

In the case where the hydroxy group-containing monomer having a polyoxyethylene chain is used, all of the hydroxy group-containing monomers may be hydroxy group-containing monomers having a polyoxyethylene chain, but it is preferred that hydroxy group-containing monomers having a polyoxyethylene chain and hydroxy group-containing monomers having no polyoxyethylene chain are used in combination.

The content of the units based on the hydroxy group-containing monomer having a polyoxyethylene chain in the all units in the fluoropolymer (A) is preferably from 0.1 to 25 mol%.

Both in the case where the hydroxy group-containing monomer having a polyoxyethylene chain is used and in the case where such a monomer is not used, the content of the units based on a hydroxy group-containing monomer in the fluoropolymer (A) is preferably adjusted to be within the above range.

As the fluoropolymer (A) containing units based on a hydroxy group-containing monomer having a polyoxyethylene chain, a fluorocopolymer disclosed in JP-A-7-179809 can be used.

Further, a part of hydroxy groups contained in the units based on a hydroxy group-containing monomer may be acid modified. The acid modification is preferably carried out in such a manner that hydroxy groups in the fluoropolymer (A) is reacted with a dicarboxylic acid or an acid anhydride of a dicarboxylic acid.

The acid anhydride is preferably succinic anhydride, phthalic anhydride, 1,2-cyclohexanedicarboxylic anhydride or cis-4-cyclohexene-1,2-dicarboxylic anhydride.

An acid modified fluoropolymer (A) and an acid modified fluoropolymer (A) having units having carboxy groups have an advantage of having improved pigment dispersibility. Further, a part or all of the carboxy groups is neutralized with a base compound, whereby an aqueous dispersible coating material containing little or no organic solvent can be obtained.

In the case where the purpose is to improve the pigment dispersibility, the total content of the units having a carboxy group in the all units in the fluoropolymer (A) is preferably adjusted to be from 0.2 to 5 mol%, more preferably from 0.5 to 3 mol%. As the content of the units having a carboxy group is larger, the effect of improvement of the pigment dispersibility is higher, as the content is smaller, the water resistance of the coating film layer is improved.

On the other hand, in the case where the purpose is to obtain an aqueous dispersible coating material, the dispersibility of the fluoropolymer (A) in water can be varied depending on the amount of carboxy groups in the polymer and the degree of neutralization of the carboxy groups. The content of the units having a carboxy group is preferably adjusted to be from 1.5 to 6 mol%, more preferably from 2 to 4 mol%, in the all units of the fluoropolymer (A). In the case where improvement of pigment dispersibility and aqueous dispersibility of the polymer are to be achieved at the same time, it is particularly preferably from 2 to 3 mol%. As the content of the units having a carboxy group is larger, the dispersibility in water is better, and as the content is smaller, the water resistance of the coating film is improved.

As the fluoropolymer (A) wherein a part of hydroxy groups contained in the units based on a hydroxy group-containing monomer is acid modified, a fluorocopolymer disclosed in WO2007/125970 pamphlet may be used.

In the case where a carboxy group of units having a carboxy group is neutralized with a base substance to obtain an aqueous dispersible coating material, it is preferred that from 30 to 100 mol%, more preferably from 70 to 100 mol%, of the all units having a carboxy group is neutralized. The units having a carboxy group may be units obtained by acid modifying units having a hydroxy group.

The base substance used for neutralization preferably has a boiling point of at most 200°C for the reason that the base substance becomes hardly likely to remain in the coating film.

The base substance may used for neutralization, for example, be ammonia; a primary, secondary or tertiary alkylamine such as monomethylamine, dimethylamine, trimethylamine, monoethylamine, diethylamine, triethylamine, monoisopropylamine, diisopropylamine, triisopropylamine, monobutylamine or dibutylamine; an alkanolamine such as monoethanolamine, monoisopropanolamine, dimethylaminoethanol or diethylaminoethanol; a diamine such as ethylenediamine, propylenediamine, tetramethylenediamine or hexamethylenediamine; an alkyleneimine such as ethyleneimine or propyleneimine; or piperazine, morpholine, pyrazine, pyridine or the like.

Further, in the case of obtaining an aqueous dispersible coating material, the organic solvent is preferably removed from the viewpoint of environmental protection. The aqueous dispersible coating material is preferably such that the organic solvent is at least 10 mass%, more preferably at most 5 mass%, further preferably at most 0.5%, in the total amount of the aqueous dispersible coating material.

The solvent to be removed may, for example, be a residue of the organic solvent used in esterification step. Further, it may also be a residue of the organic solvent used in polymerization step in the case of producing the fluoropolymer (A). The solvent can be removed under reduced pressure.

### <Alkyl group-containing monomer (c)>

The alkyl group-containing monomer (c) is a monomer wherein a C₂₋₂₀ linear or branched alkyl group having no quaternary carbon atom, and a polymerizable unsaturated group are linked to each other by an ether bond or ester bond (hereinafter such an ether bond and ester bond are collectively referred to as "a combining bond"), and is preferably represented by any one of the following formulae (2), (3) and (4):

R¹-O-R² (2)

R¹-C(O)O-R² (3)

R¹-OC(O)-R² (4)

wherein R¹ is a C₂₋₂₀ linear or branched alkyl group having no quaternary carbon atom, and R² is a polymerizable unsaturated group.

The units based on the alkyl group-containing monomer (c) imparts excellent flexibility and adhesion to a substrate to the cured coating film layer. The degrees of flexibility and adhesion to a substrate of the cured coating film layer vary depending on the combination of the structure of the alkyl group (R¹) and the type of the combining bond.

On the other hand, the combination of the type of the combining bond and the structure of the polymerizable unsaturated group (R²) has a significant influence on the copolymerizability of the alkyl group-containing monomer (c).

Accordingly, it is preferred that the combination of the structure of the alkyl group (R¹), the combining bond and the polymerizable unsaturated group (R²) is properly selected corresponding to required properties and the copolymerizability.

The structure of the alkyl group (R¹) is preferably a monovalent saturated aliphatic hydrocarbon group and preferably such a group having no quaternary carbon atom, and it may be linear or branched, and further it preferably has a ring structure. For example, a C₂₋₂₀ linear monovalent saturated aliphatic hydrocarbon group having no quaternary carbon atom or a C₂₋₂₀ branched monovalent saturated aliphatic hydrocarbon group having no quaternary carbon atom is preferred. Further, the alkyl group (R¹) has from 2 to 20 carbon atoms, but it preferably has from 2 to 9 carbons, more preferably from 2 to 6 carbon atoms, from the viewpoint of availability. Further, from the viewpoint of flexibility of the coating film, an alkyl group (R¹) of a C₈₋₁₈ linear monovalent aliphatic hydrocarbon group or branched monovalent aliphatic hydrocarbon group may also be suitably used.

In the case where an alkyl group-containing monomer (c) wherein the alkyl group (R¹) has a ring structure, it is preferably used in combination with at least one type of an alkyl group-containing monomer (c) having a linear or branched chain and having no ring structure.

The polymerizable unsaturated group (R²) is preferably a group having an ethylenic unsaturated double bond, and is preferably, for example, a vinyl group, an allyl group or a 1-propenyl group.

In the case where the combining bond is an ether bond, it is preferred that the polymerizable unsaturated group and the ether bond form a structure of vinyl ether or allyl ether. Specifically, such a structure is preferably an alkyl vinyl ether or alkyl allyl ether having a C₂₋₂₀ alkyl group.

Further, the combining bond is an ester bond, the polymerizable unsaturated group may be located at the carbonyl side of the ester bond or located at the oxygen side, but the polymerizable unsaturated group is preferably located at the oxygen side of the ester bond from the viewpoint of being hardly likely to be subject to photolysis or hydrolysis. The polymerizable unsaturated group and the ester bond preferably form a structure of a vinyl ester or an allyl ester, and such a structure is preferably, for example, a carboxylic acid vinyl ester or a carboxylic acid allyl ester. The alkyl group moiety of the carboxylic acid in this case is preferably a C₂₋₂₀ linear aliphatic hydrocarbon group or branched aliphatic hydrocarbon group.

Following are preferred combinations of the structure of the alkyl group (R¹), the combining bond, and the structure of the polymerizable unsaturated group (R²).

In the case where the alkyl group-containing monomer (c) is an alkyl vinyl ether of formula (2) and the alkyl group is a linear monovalent saturated aliphatic hydrocarbon group, the alkyl group-containing monomer (c) is preferably a linear monovalent saturated aliphatic alkyl vinyl ether such as ethyl vinyl ether, n-propyl vinyl ether, n-butyl vinyl ether or octadecyl vinyl ether. Further, in the case where the alkyl group is a branched monovalent saturated aliphatic hydrocarbon group, the alkyl group-containing monomer (c) is preferably a branched monovalent saturated aliphatic alkyl vinyl ether such as 2-ethylhexyl vinyl ether, isopropyl vinyl ether or isobutyl vinyl ether. The alkyl group-containing monomer (c) in the case of the combination wherein the alkyl group-containing monomer (c) is an alkyl vinyl ether is particularly preferably ethyl vinyl ether or 2-ethylhexyl ether.

In the case where the alkyl group-containing monomer (c) is a carboxylic acid vinyl ester of formula (3) and the alkyl group is a linear monovalent saturated aliphatic group, the alkyl group-containing monomer (c) is preferably a linear monovalent saturated aliphatic carboxylic acid vinyl ester such as vinyl propionate, vinyl butyrate, vinyl caproate, vinyl laurate or vinyl stearate. Further, in the case where the alkyl group is a branched monovalent saturated aliphatic hydrocarbon group, the alkyl group-containing monomer (c) is preferably a branched monovalent saturated aliphatic carboxylic acid vinyl ester such as vinyl vinylisobutyrate or versatic acid vinyl ester.

In the case where the alkyl group-containing monomer (c) is an alkyl allyl ether of formula (2) and the alkyl group is a linear monovalent saturated aliphatic hydrocarbon group, the alkyl group-containing monomer (c) is preferably a linear monovalent saturated aliphatic alkyl allyl ether such as ethyl allyl ether, n-propyl allyl ether, n-butyl allyl ether or octadecyl allyl ether. Further, in the case where the alkyl group is a branched monovalent saturated aliphatic hydrocarbon group, the alkyl group-containing monomer (c) is preferably a branched monovalent saturated aliphatic alkyl allyl ether such as 2-ethylhexyl allyl ether, isopropyl allyl ether or isobutyl allyl ether.

The alkyl group-containing monomer (c) in the case where the alkyl group-containing monomer (c) is an alkyl allyl ether is particularly preferably ethyl allyl ether or 2-ethylhexyl allyl ether.

In the case where the alkyl group-containing monomer (c) is a carboxylic acid allyl ester of formula (3) and the alkyl group is a linear monovalent saturated aliphatic group, the alkyl group-containing monomer (c) is preferably a linear monovalent saturated aliphatic carboxylic acid allyl ester such as allyl propionate, allyl butyrate, allyl caproate, allyl laurate or allyl stearate. Further, in the case where the alkyl group is a branched monovalent saturated aliphatic hydrocarbon group, the alkyl group-containing monomer (c) is preferably a branched monovalent saturated aliphatic carboxylic acid allyl ester such as allyl vinylisobutyrate or versatic acid allyl ester.

The alkyl group-containing monomer (c) wherein the polymerizable unsaturated group is bonded at the carbon side of the ester bond is preferably a (meth)acrylic acid ester such as ethyl methacrylate, propyl methacrylate, isopropyl methacrylate, butyl methacrylate, isobutyl methacrylate or cyclohexyl methacrylate.

The alkyl group-containing monomer (c) is preferably an alkyl vinyl ether of formula (2) or a carboxylic acid vinyl ester of the formula (3).

It is preferred that two or more types of such alkyl group-containing monomers (c) are used in combination. In such a case, it is particularly preferred that at least one member selected from ethyl vinyl ether and 2-ethylhexyl vinyl ether is contained as an essential component.

The content of units based on the alkyl group-containing monomer (c) is preferably from 10 to 50 mol% in the all units of the fluoropolymer (A).

### <Another monomer>

The fluoropolymer (A) of the present invention contains, as essential components, units based on a fluoroolefin (a), units based on a crosslinkable group-containing monomer (b) and the above alkyl group-containing monomer (c), but units based on a monomer other than the monomers (a) to (c) may also be contained corresponding to required properties.

Such another monomer is preferably a non-fluoromonomer, and is preferably a monomer having no above-described crosslinkable group.

Such another monomer is preferably, for example, a non-fluoroolefin such as ethylene, propylene, n-butene or isobutene; non-fluoroaromatic group-containing monomer such as vinyl benzoate or vinyl p-t-butyl benzoate; or t-butyl vinyl ether, vinyl pivalate or the like.

Further, a monomer having a polyethylene oxide chain and having no crosslinkable group may also be used as a unit having hydrophilic property. For example, a monomer having a polyoxyethylene chain of which the hydroxy group at the terminal is substituted by an alkoxy group or acyloxy group may be used as such another monomer.

The content of such another monomer is preferably 0 mol% or more than 0 and at most 10 mol%, in the all units in the fluoropolymer (A).

### <Combination of monomers>

The combination of the units constituting the fluoropolymer (A) is determined by the combination of monomers at the time of preparation of the fluoropolymer (A) except in the case where constituting units are directly reacted after polymerization, including e.g. acid modification. The combination of the monomers may be properly selected from the above fluoroolefin (a), crosslinkable group-containing monomer (b) and alkyl group-containing monomer (c), from the viewpoint of copolymerizability, ease of manufacture, the crosslinking system and so on, and from the above another monomer as an optional component corresponding to required properties, in combination.

The combination of the monomers is preferably, for example, a fluoroolefin/hydroxyalkyl vinyl ether/alkyl vinyl ether/another monomer copolymer, a fluoroolefin/hydroxyalkyl vinyl ether/alkyl vinyl ester/another monomer copolymer, a fluoroolefin/hydroxyalkyl allyl ether/alkyl allyl ether/another monomer copolymer, a fluoroolefin/hydroxyalkyl allyl ether/alkyl allyl ester/another monomer copolymer, a fluoroolefin/hydroxyalkyl allyl ether/alkyl vinyl ester/ another monomer copolymer or a fluoroolefin/hydroxyalkyl allyl ether/alkyl vinyl ether/another monomer copolymer.

More specifically, the combination of the monomers is preferably, for example, a CTFE/hydroxybutyl vinyl ether/ethyl vinyl ether/another monomer copolymer, a CTFE/hydroxybutyl vinyl ether/2-ethylhexyl vinyl ether/another monomer copolymer, a TFE/hydroxybutyl vinyl ether/ethyl vinyl ether/another monomer copolymer, or a TFE/hydroxybutyl vinyl ether/2-ethylhexyl vinyl ether/another monomer copolymer.

In the case where the above copolymer has hydroxy groups, a copolymer having a part of the hydroxy groups acid-modified is also preferred.

Further, combinations in the above preferred combinations of the monomers, wherein another monomer is not contained, may be also preferred combinations.

### [Preparation process of polymer]

The fluoropolymer (A) in the present invention is obtained by solution polymerization.

When a polymer is made into a coating material, the concentration of the polymer after polymerization is adjusted if necessary, and then, the polymer is used as a starting material for preparing a coating material, in the form of an aqueous dispersible polymer obtained by having a polymer obtained by the solution polymerization dispersed in water from the viewpoint of water resistance of the coating layer.

The method of dispersing in water is preferably such that units having a carboxy group are introduced into the fluoropolymer (A) by the above method; water dilution is carried out while the carboxy groups are neutralized with a base compound; and further the organic solvent is removed under reduced pressure. Further, a fluoropolymer (A) having a side chain having a polyoxyethylene chain may be obtained by copolymerizing monomers having a polyoxyethylene chain, and the obtained fluoropolymer (A) may be dispersed in water to obtain an aqueous dispersion as an aqueous dispersible coating material.

In preparing an aqueous dispersible polymer, the medium in which the polymer is dispersed is preferably water or a mixed medium of water and a water-soluble organic solvent, more preferably singly water. The water-soluble organic solvent is preferably acetone, methyl ethyl ketone, isopropyl alcohol or the like.

The solid content in the above polymer solution or aqueous dispersible polymer is preferably from 20 to 80 mass% in the case of the polymer solution, and from 30 to 70 mass% in the case of the aqueous dispersible polymer.

### [Preparation of coating material]

The coating material used in the present invention is prepared by, to the above aqueous dispersible polymer, corresponding to required properties, adding a curing agent, a curing promoter, an adhesion improver, a pigment, a leveling agent, an ultraviolet absorbing agent, a light stabilizer, a thickening agent, a matting agent and a surface conditioner, and adjusting the concentration.

The curing agent may be properly selected corresponding to the crosslinkable group contained in the fluoropolymer (A).

For example, an isocyanate curing agent, a melamine resin, a silicate compound, an isocyanate-containing silane compound or the like is selected.

Particularly in the case where the fluoropolymer has a hydroxy group, the curing agent is preferably a polyisocyanate, more preferably, among polyisocyanates, a non-yellowing polyisocyanate or a modified body of a non-yellowing polyisocyanate.

The non-yellowing modified polyisocyanate is preferably IPDI (isophorone diisocyanate), HMDI (hexamethylene diisocyanate), HDI (hexane diisocyanate) or a modified body thereof.

The modified body is preferably, for example, a polyisocyanate having the isocyanate group blocked using ε-caprolactam (E-CAP), methyl ethyl ketone oxime (MEK-OX), methylisobutyl ketone oxime (MIBK-OX), pyraridine or triazine (TA), or polyisocyanates having the polyisocyanate groups coupled to form a urethodion bond. Further, the modified body is preferably an adduct in order to form a solid at normal temperature, or an emulsion using a hydrophilic moiety or an emulsifier in order to be likely to be dispersed in water. When an aqueous dispersible coating material is prepared, such a polyisocyanate having a hydrophilic moiety or a polyisocyanate emulsified in water is preferably used as a curing agent.

As the curing promoter, for example, a tin-, another metallic-, organic acid-, or amine-curing promoter may be used.

The adhesion improver is not particularly limited, but is, for example, a silane coupling agent may be preferably used. The silane coupling agent is preferably, for example, an aminoalkylsilane such as 3-aminopropyltriethoxysilane, 3-aminopropyltrimethoxysilane, N-2-(aminoethyl)-3-aminopropyltrimethoxysilane or ureidopropyltriethoxysilane; an unsaturated alkylsilane such as vinyltriethoxysilane, vinyltrimethoxysilane, 3-methacryloxypropyltrimethoxysilane or 3-methacryloxypropyltriethoxysilane; an epoxysilane such as 2-(3,4-epoxycyclohexyl)ethyltrimethoxysilane or 3-glycidoxypropyltrimethoxysilane; or 3-mercaptopropyltrimethoxysilane, 3-isocyanatepropyltriethoxysilane, methyltriethoxysilane, methyltrimethoxysilane or the like.

The pigment has effects of improving esthetic appearance of the backsheet, increasing light use efficiency by reflecting light, and so on. As the pigment, for example, a white pigment such as titanium oxide or calcium carbonate, a black pigment such as carbon black, or another pigment such as a composite metal is added.

Among such pigments, titanium oxide as a white pigment is known for decomposing and deteriorating the coating film layer containing the pigment by the photocatalytic action. Accordingly, it is preferred to use a titanium oxide made into composite particles which comprises, sequentially from the center, particles containing titanium oxide, a first covering layer covering the above particles and containing cerium oxide, and a second covering layer covering the first coating film layer and containing silicon oxide.

The composite particles may have another covering layer inside or outside of the cerium oxide covering layer and the silicon oxide covering layer. For example, it is preferred that the composite particles have a covering layer of silicon oxide between the particles containing titanium oxide and the first covering layer covering the particles and containing cerium oxide.

Further, to the outermost covering layer of the composite particles, corresponding to required properties for the composite particles, a metal compound other than the metal compound constituting the covering layer is preferably added. For example, it is preferred that zirconia is added in order to harden the covering layer to keep the pigment from collapsing, or alumina is added in order to increase the hydrophilic property to improve the aqueous dispersibility. In the case where the outermost layer of the above composite particles is the above second layer containing silicon oxide, it is preferred that the above zirconia or alumina is added to silicon oxide. When a metal compound other than the metal compound constituting the covering layer is added to the covering layer, the amount of the metal compound to be added is preferably from 10 to 50 mass%, more preferably from 20 to 30 mass%, in the total mass of the metal compounds constituting the covering layer.

The leveling agent is preferably, for example, a polyether modified polydimethylsiloxane or a polyether modified siloxane.

Since solar cells are used outside for a long period, where ultraviolet rays are strong, the countermeasure against the deterioration of the backsheet by ultraviolet rays is important. Accordingly, it is preferred that an ultraviolet absorbing agent is added to the coating material containing the fluoropolymer (A) as an essential component to impart a function to absorb ultraviolet rays to the cured coating film layer.

As the ultraviolet absorbing agent, each of an organic ultraviolet absorbing agent and an inorganic ultraviolet absorbing agent may be used. Such an organic compound may, for example, be a ultraviolet absorbing agent of a salicylic acid ester, of a benzotriazole, of a benzophenone, or of a cyanoacrylate; and such an inorganic compound is preferably a filler-type inorganic ultraviolet absorbing agent such as titanium oxide, zinc oxide or cerium oxide.

When titanium oxide is used as the ultraviolet absorbing agent, it is preferred to use the above titanium oxide made into composite particles.

One type of the ultraviolet absorbing agent may be used singly, or two or more types may be used in combination. The amount of the ultraviolet absorbing agent is preferably from 0.1 to 15 mass% in the total mass of the solid content of the fluoropolymer (A) in the coating material. If the amount of the ultraviolet absorbing agent is too small, the effect of improving the light resistance cannot be sufficiently obtained, and if it is too large, the effect will be saturated.

The light stabilizer may, for example, be a hindered amine light stabilizer, and is preferably, for example, ADK STB LA-62, ADK STB LA-67 (by product names, manufactured byADEKAARGUS CHEMICAL Co., Ltd.), TINUVIN 292, TINUVIN 144, TINUVIN 123 or TINUVIN 440 (by product names, manufactured by Ciba Specialty Chemicals).

One type of the light stabilizer or two or more types in combination may be used, and the light stabilizer may be used in combination with the ultraviolet absorbing agent.

The thickening agent may, for example, be a polyurethane associative thickening agent.

As the matting agent, a common inorganic or organic matting agent such as an ultrafine powdered synthetic silica may be used.

The polymer concentration in the coating material prepared as above is preferably from 20 to 70 mass% in the all mass of the coating material.

In the case where an aqueous dispersible polymer is used to prepare the coating material, at the time of application to a substrate sheet such as PET, which will be described later, the wettability of the coating material to the substrate is not sufficient, and therefore, in some cases, the coating material cannot be uniformly applied due to the repellency. In such a case, it is effective to add a surface conditioner to improve the wettability.

The surface conditioner may, for example, be a silicon surface conditioner such as a polyether modified polydimethylsiloxane or a polyether modified polymethylalkylsiloxane, or a resin surface conditioner containing an acrylic copolymer or a fluorine modified polymer as a main component. The optimal amounts of the additives differ from one another, but usually, the amount is about from 0.05 to 1.0 wt% in the coating material.

The surface tension is preferably adjusted to be at most 44 dyn/cm, preferably at most 41 dyn/cm.

### [Substrate sheet]

Material of the substrate sheet is not particularly limited, and a polyolefin such as polyethylene or polypropylene; a polyvinyl halide such as polyvinyl chloride, polyvinylidene chloride, polyvinyl fluoride or polyvinylidene fluoride; a polyester such as PET or polybutylene terephthalate; a polyamide such as Nylon 6, Nylon 66 or MXD nylon (methaxylenediamine/adipic acid copolymer); a polymer of an olefin having a substituted group such as polyvinyl acetate, polyvinyl alcohol or polymethyl methacrylate; or a copolymer such as EVA, an ethylene/vinyl alcohol copolymer or an ethylene/tetrafluoroethylene copolymer, may be used.

Among them, PET, EVA, polyvinyl alcohol, polyvinylidene chloride, Nylon 6, Nylon 66 or an ethylene/vinyl alcohol copolymer is preferred.

The backsheet of the present invention has a coating film layer and a substrate sheet, whereby it has water/moisture-proof property. However, higher water/moisture-proof property is required under a certain condition of use of a solar cell. In such a case, a layer comprising a metal or a metal compound (hereinafter, a metal and a metal compound are collectively referred to as "a metal", and the layer comprising a metal or a metal compound will be collectively referred to as "a metal layer") is preferably provided on one or each side of the substrate sheet to obtain a water-impermeable sheet.

The metal layer may be provided by vapor-depositing a metal or a metal compound on the surface of the substrate sheet or adhering a foil of a metal or a metal compound with an adhesive to the surface of the substrate sheet. The foil and the substrate sheet are preferably adhered via an adhesive layer made of an adhesive.

The metal is preferably one excellent in water/moisture-proof property and having high corrosion resistance. Further, in the case where a metal layer is provided by vapor-deposition, a metal may be selected from metals which are further able to be vapor-deposited.

The metal may, for example, be a metal selected from the group consisting of silicon, magnesium, zirconium, zinc, tin, nickel, titanium and aluminum, a compound of such a metal or a stainless steel. Among them, the metal used for vapor-deposition is preferably silicon, aluminum, aluminum oxide, silicon oxide, silicon nitride-oxide or silicon nitride. In the vapor-deposition, one type of such a metal may be used, or two or more types of such metals may be used in combination.

On the other hand, the metal in the case where a foil of a metal is adhered with an adhesive is preferably aluminum, titanium or a stainless steel.

### [Construction of backsheet]

The backsheet of the present invention comprises the above substrate sheet and a cured coating film layer of a coating material containing the above fluoropolymer (A) as an essential component formed on one side or each side of the substrate sheet. Hereinafter, the surface of the substrate sheet at the side of a solar cell will be referred to as an inner surface, and the surface at the side opposite to the solar cell will be referred to as an outer surface.

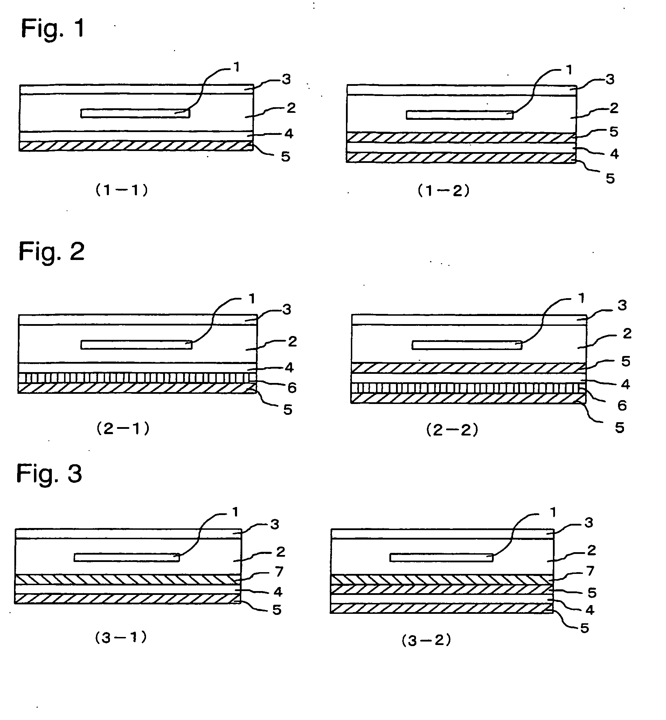

Fig. 1 shows embodiments wherein a cured coating film layer is formed on one side of a substrate sheet, and Fig. (1-1) is for the case where the cured coating film layer is formed on the outer surface, and Fig. (1-2) is for the case where the cured coating film layer is formed on each side of the substrate sheet.

The cured coating film layer is preferably formed only on the outer surface of the substrate sheet or on the surface of the substrate sheet, from the viewpoint of weatherability. Further, from the viewpoint of economic efficiency and lightening, the coating film layer is preferably formed only on the outer surface of the substrate sheet. That is, the preferred constitution of the backsheet is the constitution of Fig. (1-1), which has a substrate sheet and a coating film layer laminated on the outer surface of the substrate sheet.

In the case where the substrate sheet has a metal layer, the metal layer is provided on one or each surface of the substrate sheet, but it is usually provided only on one surface from an economic viewpoint. In order to efficiently prevent the substrate sheet from deterioration due to water, the embodiment of Fig. (2-1) or Fig. (2-2) in Fig. 2 is preferred, wherein a metal layer is provided on the outer surface of the substrate sheet having a possibility of intrusion of water. Further, the preferred construction of the backsheet in the case of having a metal layer is the construction of Fig. (2-1) which comprises a substrate sheet, a metal sheet laminated on the outer surface of the substrate sheet and a coating film layer laminated on the outer surface of the metal layer.

Further, when a cured coating film layer is formed on the surface of the substrate sheet which may have a metal layer, the cured coating film layer may be directly formed, or the cured coating film layer may be formed after a primer layer is formed. In the case where the cured coating film layer is directly formed, it is preferably by means of directly applying a coating material containing the fluoropolymer (A) as an essential component. In the case where a primer layer is formed, it is preferred that a coating material for primer is applied to the surface of the substrate sheet which may have a metal layer, and then a coating material containing the fluoropolymer (A) as an essential component is applied. The primer coating material may, for example, be an epoxy resin, a urethane resin, an acrylic resin, a silicone resin or a polyester resin.

Further, the backsheet of the present invention may have a layer of another polymer (hereinafter also referred to as polymer (B)) laminated on the outermost surface which contacts with a sealing material layer at the inner surface side. Such another polymer layer is preferably a layer comprising a polymer other than the above cured coating film layer, and for example, the polymer provided as an example of the above material of the substrate sheet may be adapted. The polymer layer is preferably an EVA layer which can improve the adhesion to a resin (hereinafter referred to as a sealing resin) which seals a solar cell.

The polymer layer may be directly provided on the substrate sheet of the backsheet, or may be provided on another layer via such another layer such as a cured coating film layer between the polymer layer and the substrate sheet.

Fig. 3 shows embodiments of the backsheet of the present invention, each of which has an EVA layer on the surface contacting with a sealing material layer at the inner surface side, and the embodiments of Fig. (3-1) and Fig. (3-2) are such that an EVA layer is formed on the surface contacting with the sealing material layer at the inner surface side in the embodiments of the backsheet of Fig. (1-1) and Fig. (1-2), respectively. In such embodiments, a metal layer may be provided on one side or each side of the substrate sheet, and it is particularly preferred that a metal layer is provided only on the outer surface of the substrate sheet.

Further, when the adhesion between respective layers forming the backsheet is low, a layer (hereinafter referred to as an adhesive layer) of another compound having adhesion may be provided.

For example, an adhesive layer is provided between the substrate sheet and a metal foil in the case where a metal layer comprising a metal foil is formed on the surface of the substrate sheet. Further, in order to improve adhesion of another polymer (B) layer, an adhesive layer may be provided on one surface or each surface of such another polymer (B) layer, preferably on one side of such another polymer (B) layer. In the case where such another polymer (B) layer is made of EVA, it is preferred that an adhesive layer is provided on the surface of the EVA layer at the side opposite to the surface contacting with the sealing material layer. In the case where such another polymer layer is made of EVA and the sealing material layer is made of EVA, both layers may be adhered to each other by compression. The adhesive may be properly changed according to the materials of the layers to be laminated, but it may, for example, be a polyester adhesive, an acrylic adhesive, a urethane adhesive, an epoxy adhesive, a polyamide adhesive or a polyimide adhesive.

Further, in the backsheet of the present invention, another layer may be formed between respective layers described as above, on the surface contacting with the sealing material and on the outermost surface, as necessary.

The backsheet of the present invention preferably has a high electrical insulation. In order to have a high electrical insulation, each layer constituting the backsheet is preferably composed of a material having a low permittivity. For example, an adhesive having a low permittivity is preferably used for the adhesive layer, and an epoxy adhesive, a polyamide adhesive or a polyimide adhesive is more preferred from the viewpoint of low permittivity. The permittivity is preferably at most 3.5, more preferably at most 3.3, most preferably at most 3.0, although it depends on the required properties for a solar cell module. The permittivity in the present invention is a value measured by the method in accordance with JIS C-2151, and is a value measured at 1 kHz at 23°C.

The thickness of each layer constituting the backsheet may be changed corresponding to the required properties. For example, the thickness of the cured coating film layer of a coating material containing a fluoropolymer (A) as an essential component is preferably from 5 to 75 µm. The thickness of the metal layer is preferably 0.01 to 50 µm. The thickness of the substrate sheet is preferably 25 to 200 µm. The thickness of another polymer (B) layer is preferably from 50 to 200 µm. The thickness of the adhesive layer is from 0.1 to 25 µm. Further, the total film thickness of the backsheet of the present invention is preferably from 30 to 300 µm.

### [Solar cell]

The backsheet of the present invention constitutes a solar cell module in combination with a solar cell. Usually, a surface sheet, a sealing layer wherein a solar cell is sealed with a resin and a backsheet are laminated in this order to constitute a solar cell module. Further, when the adhesive by the lamination is insufficient, an adhesive layer may be provided.

As the surface sheet, a glass substrate is usually used, but a flexible material such as a resin sheet may also be used. The backsheet of the present invention has a thin film and enables lightening, and therefore it may be suitably used for a flexible solar cell.

### EXAMPLES

Now, the present invention will be described in detail with reference to Examples. It should be understood, however, that the present invention is by no means limited to these Examples.

The meanings of the abbreviations in Examples are as follows.
CTFE: Chlorotrifluoroethylene
EVE: Ethyl vinyl ether
CHVE: Cyclohexyl vinyl ether
HBVE: 4-Hydroxybutyl vinyl ether
CHMVE: CH₂=CHOCH₂-Cy-CH₂OH (Cy represents a 1,4-cyclohexylene group, hereinafter the same in the following description.)
CM-EOVE: CH₂=CHOCH₂-Cy-CH₂O(CH₂CH₂O)ₙH (n is a number with which the average molecular weight of CM-EOVE is 830.)
PBPV: Perbutyl perpivalate

### [Synthetic Examples of fluoropolymer (A1) to (A8)]

### <Synthetic Example of fluoropolymer (A1)>

Into a stainless pressure-resistant reactor having an inner volume of 2,500 ml equipped with a stirrer, 590 g of xylene, 170 g of ethanol, 206 g of EVE, 129 g of HBVE, 208 of g CHVE, 11 g of calcium carbonate and 3.5 g of PBPV were charged, and dissolved oxygen in the liquid was removed by deaeration with nitrogen. Next, 660 g of CTFE was introduced and the temperature was gradually raised, and the reaction was continued while the temperature was maintained at 65°C.

After 10 hours, the reactor was water-cooled to stop the reaction. This reaction liquid is cooled to room temperature, and then unreacted monomers were purged, followed by filtrating of the obtained reaction liquid with diatomaceous earth to remove solids. Next, a part of xylene and ethanol were removed under reduced pressure to obtain a fluoropolymer solution (A1) containing monomer units as shown in Table 1. The hydroxy value of the fluoropolymer was 50 mgKOH/g, and the solid content concentration in the fluoropolymer solution was 60%.

### <Synthetic Example 2>

To 300 g of the fluoropolymer solution (A1) in Synthetic Example 1, 1.6 g of succinic anhydride and 0.072 g of triethylamine as a catalyst were added, and they were subjected to reaction at 70°C for 6 hours to be esterified, to obtain a fluoropolymer solution (A2). The infrared absorption spectrum of the reaction liquid was measured, and the characteristic absorption of an acid anhydride (1,850 cm⁻¹, 1,780 cm⁻¹) which was observed before the reaction was found to disappear after the reaction, and absoprtions of a carboxylic acid (1,710 cm⁻¹) and of an ester (1,735 cm⁻¹) were observed. After esterification, a fluoropolymer solution (A2) containing monomer units as shown in Table 1 was obtained. The hydroxy value of the fluoropolymer was 45 mgKOH/g, the acid value was 5 mgKOH/g, and the solid concentration in the fluoropolymer solution was 60%.

### <Synthetic Example 3>

Into a stainless pressure-resistant reactor having an inner volume of 2,500 ml equipped with a stirrer, 590 g of xylene, 170 g of ethanol, 350 g of EVE, 140 g of HBVE, 11 g of calcium carbonate and 3.5 g of PBPV were charged, and dissolved oxygen in the liquid was removed by deaeration with nitrogen. Next, 715 g of CTFE was introduced and the temperature was gradually raised, and the reaction was continued while the temperature was maintained at 65°C.

After 10 hours, the reactor was water-cooled to stop the reaction. This reaction liquid is cooled to room temperature, and then unreacted monomers were purged, followed by filtrating of the obtained reaction liquid with diatomaceous earth to remove solids. Next, a part of xylene and ethanol were removed under reduced pressure to obtain a fluoropolymer solution (A3) as shown in Table 1. The hydroxy value of the fluoropolymer was 50 mgKOH/g, and the solid content concentration in the fluoropolymer solution was 60%.

### <Synthetic Example 4>

A fluoropolymer solution (A4) containing monomer units as shown in Table 1 was obtained in the same manner as in Synthetic Example 2 except that the fluoropolymer solution (A3) was used instead of the fluoropolymer solution (A1). The hydroxy value of the fluoropolymer was 45 mgKOH/g, the acid value was 5 mgKOH/g, and the solid concentration in the fluoropolymer solution was 60%.

### <Synthetic Example 5>

Into a stainless pressure-resistant reactor having an inner volume of 2,500 ml equipped with a stirrer, 590 g of xylene, 200 g of ethanol, 380 g of CHVE, 130 g of HBVE, 270 g of 2-ethylhexyl vinyl ether, 11 g of calcium carbonate and 3.5 g of PBPV were charged, and dissolved oxygen in the liquid was removed by deaeration with nitrogen.

Next, 690 g of CTFE was introduced and the temperature was gradually raised, and the reaction was continued while the temperature was maintained at 65°C.

After 10 hours, the reactor was water-cooled to stop the reaction. This reaction liquid is cooled to room temperature, and then unreacted monomers were purged, followed by filtrating of the obtained reaction liquid with diatomaceous earth to remove solids. Next, a part of xylene and ethanol were removed under reduced pressure to obtain a fluoropolymer solution (A5) containing monomer units as shown in Table 1. The hydroxy value of the fluoropolymer was 50 mgKOH/g, and the solid content concentration in the fluoropolymer solution was 60%.

### <Synthetic Example 6>

Into a stainless pressure-resistant reactor having an inner volume of 2,500 ml equipped with a stirrer, 622 g of ethyl-3-ethoxypropionate, 176 g of ethanol, 334 g of HBVE, 92 g of EVE, 11 g of calcium carbonate and 3.5 g of PBPV were charged, and dissolved oxygen in the liquid was removed by deaeration with nitrogen.

Next, 515 g of CTFE was introduced and the temperature was gradually raised, and the reaction was continued while the temperature was maintained at 65°C.

After 10 hours, the reactor was water-cooled to stop the reaction. This reaction liquid is cooled to room temperature, and then unreacted monomers were purged, followed by filtrating of the obtained reaction liquid with diatomaceous earth to remove solids. Next, a part of ethyl-3-ethoxypropionate and ethanol were removed under reduced pressure to obtain a fluoropolymer solution (A6) containing monomer units as shown in Table 1. The hydroxy value of the fluoropolymer was 175 mgKOH/g, and the solid content concentration in the fluoropolymer solution was 60%.

### <Synthetic Example 7>

Into a stainless autoclave having an inner volume or 2,500 ml equipped with a stirrer, 1,280 g of water, 185 g of EVE, 244 g of CHVE, 47 g of CM-EOVE, 194 g of CHMVE, 1,280 g of ion-exchanged water, 2.0 g of potassium carbonate (K₂CO₃), 1.3 g of ammonium persulfate (APS), 33 g of a nonionic emulsifier (Newcol-2320, manufactured by Nippon Nyukazai Co., Ltd.) and 1.4 g of an anionic emulsifier (sodium lauryl sulfate) were charged, followed by cooling with ice and deaeration by applying pressure with nitrogen gas so that the pressure became 3.5 kg/cm². This pressure deaeration was repeated twice, followed by deaeration at 10 mmHg to remove dissolved air, and then 664 g of CTFE was charged, followed by reacting at 50°C for 24 hours. After the reaction for 24 hours, the reactor was water-cooled to stop the reaction. This reaction liquid was cooled to room temperature, and unreacted monomers were purged to obtain a fluoropolymer solution (A7) containing monomer units as shown in Table 1. The hydroxy value of the fluoropolymer was 55 mgKOH/g, and the solid concentration in the fluoropolymer solution was 50%.

### <Synthetic Example 7-2>

Into a stainless autoclave having an inner volume or 2,500 ml equipped with a stirrer, 1,280 g of water, 259 g of 2-ethylhexyl vinyl ether (2EHVE), 468 g of CHVE, 17 g of CM-EOVE, 38 g of CHMVE, 1,280 g of ion-exchanged water, 2.0 g of potassium carbonate (K₂CO₃), 1.3 g of ammonium persulfate (APS), 33 g of a nonionic emulsifier (Newcol-2320, manufactured by Nippon Nyukazai Co., Ltd.) and 1.4 g of an anionic emulsifier (sodium lauryl sulfate) were charged, followed by cooling with ice and deaeration by applying pressure with nitrogen gas so that the pressure became 3.5 kg/cm². This pressure deaeration was repeated twice, followed by deaeration at 10 mmHg to remove dissolved air, and then 664 g of CTFE was charged, followed by reacting at 50°C for 24 hours. After the reaction for 24 hours, the reactor was water-cooled to stop the reaction. This reaction liquid was cooled to room temperature, and unreacted monomers were purged to obtain a fluoropolymer solution (A7-2) containing monomer units as shown in Table 1. The hydroxy value of the fluoropolymer was 10 mgKOH/g, and the solid concentration in the fluoropolymer solution was 50%.

### <Synthetic Example 8>

Lumiflon manufactured by Asahi Glass Company, Limited was dissolved in methyl ethyl ketone (MEK) to obtain a varnish having a solid content of 60 mass%. To 300 g of the varnish, 4.8 g of succinic anhydride and 0.072 g of triethylamine as a catalyst were added, and they were subjected to reaction at 70°C for 6 hours to be esterified. The infrared absorption spectrum of the reaction liquid was measured, and the characteristic absorption of an acid anhydride (1,850 cm⁻¹, 1,780 cm⁻¹) which was observed before the reaction was found to disappear after the reaction, and absoprtions of a carboxylic acid (1,710 cm⁻¹) and of an ester (1,735 cm⁻¹) were observed. The hydroxy value of the fluoropolymer after esterification was 85 mgKOH/g, the acid value was 15 mgKOH/g, and the solid concentration in the fluoropolymer solution was 60%.

Next, to the fluorocopolymer after esterification, 4.9 g of triethylamine was added, and the mixture was stirred at room temperature for 20 minutes to neutralize the carboxylic acid, followed by incremental addition of 160 g of ion-exchanged water.

Finally, acetone and methyl ethyl ketone were removed under reduced pressure. Further 20 parts by gram of ion-exchanged water was added to obtain a fluoropolymer solution (A8) having a solid concentration of 50 mass%.

### <Synthetic Example 8-2>

Dissolution, esterification, neutralization and vacuum distillation of solvent were carried out in the same manner as in Synthetic Example 8 except that 3.8 g of succinic anhydride was used and the amount of triethylamine used for neutralization was changed to 3.9 g, to obtain a fluoropolymer solution (A8-2) having a solid concentration of 50 mass%. The hydroxy value of the fluorocopolymer after esterification was 87 mg/KOH, and the acid value was 12 mgKOH/g.

Each polymer used in Examples in the present invention is a copolymer containing monomer units in the proportion shown in the following Table.

The unit for the numbers in the Table is mol%. Notes in the Table represent the following meanings.
(Note 1) 1 mol% of units of HBVE of which hydroxy group is acid-modified by succinic anhydride is contained.
(Note 2) 15 mol% of units of 2-ethylhexyl vinyl ether is contained.
(Note 3) 10 mol% of units of CHMVE is contained.
(Note 4) 0.5 mol% of units of CM-EOVE is contained.
(Note 5) 14.7 mol% of units of 2-ethylhexyl vinyl ether is contained.
(Note 6) 2 mol% of units of CHMVE is contained.
(Note 7) 0.3 mol% of units of CM-EOVE is contained.

**TABLE 1**

| Fluoropolymer solution | CTFE | EVE | CHVE | HBVE | Another monomer units |
|---|---|---|---|---|---|
| A1 | 50 | 25 | 15 | 10 | 0 |
| A2 | 50 | 25 | 15 | 9 | 1 (Note 1) |
| A3 | 50 | 40 | 0 | 10 | 0 |
| A4 | 50 | 40 | 0 | 9 | 1 (Note 1) |
| A5 | 50 | 0 | 25 | 10 | 15 (Note 2) |
| A6 | 50 | 15 | 0 | 35 | 0 |
| A7 | 50 | 22.5 | 17 | 0 | 10 (Note 3) |
| | | | | | 0.5 (Note 4) |
| A7-2 | 50 | 0 | 33 | 0 | 14.7 (Note 5) |
| | | | | | 2 (Note 6) |
| | | | | | 0.3 (Note 7) |
| A8 | 50 | 15 | 15 | 20 | 0 |
| A8-2 | 50 | 15 | 15 | 20 | 0 |

### [Preparation of composite particles]

### <Preparation of composite particle (C)>

500 g of titanium oxide pigment (CR50, manufactured by Ishihara Sangyo Kaisha, Ltd., average particle size: 0.20 µm) was added to 10 L of pure water, and it was dispersed using DESPA MILL (manufactured by Hosokawa Micron Corporation) for 1 hour to obtain an aqueous dispersion. While the aqueous dispersion was heated to 80°C and stirred, 264 g of cerium nitrate aqueous solution (cerium content: 10 mass% as calculated as CeO₂) was dropped into the aqueous dispersion. A sodium hydroxide solution was added to the aqueous dispersion, and the dispersion was neutralized to pH 7 to 9 to deposit cerium hydroxide on the surface of the titanium oxide pigment. The dispersion containing the particles covered with cerium oxide was filtrated, and the particles covered with cerium hydroxide were washed with water and dried. A mass of the particles covered with cerium hydroxide was crushed to obtain particles covered with cerium hydroxide.

The particles covered with cerium hydroxide was added to 10 L of pure water, and it was dispersed using DESPA MILL for 1 hour to obtain an aqueous dispersion. While the aqueous dispersion was heated to 80°C and stirred, 348 g of sodium silicate No. 3 (silicon content: 28.5 mass% as calculated as SiO₂) was added to the aqueous dispersion. Then, diluted sulfuric acid was also added to maintain pH of the dispersion at 9 to 11 followed by stirring continued for 1 hour, and then sulfuric acid was added to adjust pH of the dispersion to be 6 to 8, to form a second covering layer of the particles covered with cerium oxide. The dispersion containing precursor particles was filtrated, and the precursor particles were washed with water and dried. A mass of the precursor particles was crushed to obtain the precursor particles.

The precursor particles were fired at a temperature of 500°C for 2 hours, and then a mass of the particles was crushed with a hammer mill to obtain composite particles (C) having an average particle size of 0.25 µm. The titanium oxide content in the composite particles was 72 mass%, cerium oxide content was 10 mass%, and silicon oxide content was 18 mass%. Accordingly, the amount of cerium oxide per 100 parts by mass of titanium oxide was 13.9 parts by mass, and the amount of silicon oxide per 100 parts by mass of titanium oxide was 25.0 parts by mass.

### [Preparation of pigment composition]

### <Pigment composition (B1)>

To 83 g of the obtained fluoropolymer solution (A1), 200 g of titanium oxide (manufactured by Ishihara Sangyo Kaisha, Ltd., product name: CR-90), 43 g of xylene and 43 g of butyl acetate were added, and further, 369 g of glass beads having a diameter of 1 mm was added, followed by stirring with a paint shaker for 2 hours. After the stirring, the glass beads were removed by filtration to obtain a pigment composition (B1).

### <Resin pigment compositions (B2) to (B6)>

Pigment compositions (B2) to (B6) were obtained in the same manner as the pigment composition (B1) except that the fluoropolymer solutions (A2) to (A6) were respectively used instead of the fluoropolymer solution (A1).

### <Pigment composition (B1-a)>

A pigment composition (B1-a) was obtained in the same manner as the resin pigment composition (B1) except that the composite particles (C) were used instead of titanium oxide (manufactured by Ishihara Sangyo Kaisha, Ltd., product name: CR-90).

### <Pigment composition (B7)>

210 Parts of titanium oxide (Tipure R-706, manufactured by DuPont), 21 parts of a pigment dispersing agent Disperbyk 190 (manufactured by BYK-Chemie, a copolymer having affinity to a pigment, acid value: 10 mgKOH/g), 4.5 parts of an antifoaming agent DEHYDRAN 1620 (manufactured by Cognis), 64.5 parts of ion-exchanged water and 300 parts of glass beads were mixed and dispersed using a disperser, and the glass beads were removed by filtration to prepare a pigment composition (B7).

### [Coating material composition]

### <Coating material composition (D1)>

To 100 g of the pigment composition (B1), 150 g of the fluoropolymer solution (A1), 3 g of 10⁻⁴ times-diluted dibutyltin dilaurate with xylene and a HDI nurate-type polyisocyanate resin (manufactured by Nippon Polyurethane Industry Co., Ltd., product name: CORONATE HX) were added and mixed to obtain a coating material composition (D1).

### <Coating material composition (D2)>

A coating material composition (D2) was obtained in the same manner as the coating material composition D1 except that the pigment composition (B2) was used instead of the pigment composition (B1), and the fluoropolymer solution (A2) was used instead of the fluoropolymer solution (A1).

### <Coating material composition (D3)>

A coating material composition (D3) was obtained in the same manner as the coating material composition D1 except that the pigment composition (B3) was used instead of the pigment composition (B1), and the fluoropolymer solution (A3) was used instead of the fluoropolymer solution (A1).

### <Coating material composition (D4)>

A coating material composition (D4) was obtained in the same manner as the coating material composition D1 except that the pigment composition (B4) was used instead of the pigment composition (B1), and the fluoropolymer solution (A4) was used instead of the fluoropolymer solution (A1).

### <Coating material composition (D5)>

A coating material composition (D5) was obtained in the same manner as the coating material composition D1 except that the pigment composition (B5) was used instead of the pigment composition (B1), and the fluoropolymer solution (A5) was used instead of the fluoropolymer solution (A1).

### <Coating material composition (D6)>

A coating material composition (D6) was obtained in the same manner as the coating material composition D1 except that the pigment composition (B6) was used instead of the pigment composition (B1), and the fluoropolymer solution (A6) was used instead of the fluoropolymer solution (A1).

### <Coating material composition (D1-a)>

A coating material composition (D1-a) was obtained in the same manner as the coating material composition D1 except that the pigment composition (B1-a) was used instead of the pigment composition (B1).

### <Coating material composition (D1-b)>

A coating material composition (D1-b) was obtained in the same manner as the coating material composition D1 except that the pigment composition (B1-a) was used instead of the pigment composition (B1) and 10 g of TINUVIN 384 and 3 g of TINUVIN 400, which are ultraviolet absorbing agents manufactured by Ciba Specialty Chemicals, were added.

### <Coating material composition (D7-a)>

To 55 g of the pigment composition (B7), 193 g of the fluoropolymer solution (A7), 15 g of dipropylene glycol mono n-butyl ether and 0.5 part of a thickening agent BERMODOL 2150 (manufactured by AKZO Nobel) were added and mixed to obtain a coating material composition (D7-a).

### <Coating material composition (D7-b)>

To 55 g of the pigment composition (B7), 193 g of the fluoropolymer solution (A7), 0.5 part of a thickening agent BERMODOL 2150 (manufactured by AKZO Nobel), 10 g of dipropylene glycol mono n-butyl ether and 15 parts of an aqueous dispersing-type isocyanate curing agent Bayhydur 3100 (manufactured by Sumika Bayer) were added and mixed to obtain a coating material composition (D7-b).

### <Coating material composition (D7-c)>

To 55 g of the pigment composition (B7), 193 g of the fluoropolymer solution (A7-2), 15 g of dipropylene glycol mono n-butyl ether and 0.5 part of a thickening agent BERMODOL 2150 (manufactured by AKZO Nobel) were added and mixed to obtain a coating material composition (D7-c).

### <Coating material composition (D8)>

To 55 g of the pigment composition (B7), 193 g of the fluoropolymer solution (A8), 1.3 parts of a surface conditioner BYK-348 (a polyether-modified polydimethylsiloxane, manufactured by BYK-Chemie), 0.5 part of a thickening agent BERMODOL 2150 (manufactured by AKZO Nobel) and 25 parts of an aqueous dispersing-type isocyanate curing agent Bayhydur 3100 (manufactured by Sumika Bayer) were added and mixed to obtain a coating material composition (D8).

### <Coating material composition (D8-b)>

To 55 g of the pigment composition (B7), 193 g of the fluoropolymer solution (A8-2), 1.3 parts of a surface conditioner BYK-348 (a polyether-modified polydimethylsiloxane, manufactured by BYK-Chemie), 0.5 part of a thickening agent BERMODOL 2150 (manufactured by AKZO Nobel) and 25 parts of an aqueous dispersing-type isocyanate curing agent Bayhydur 3100 manufactured by Sumika Bayer) were added and mixed to obtain a coating material composition (D8-b).

### EXAMPLES

On one surface of PET films having a thickness of 50 µm, coating material compositions (D1), (D1-a), (D1-b), (D2), (D3), (D4), (D5), (D6), (D7-a), (D7-b), (D8) and (D8-b) respectively were applied so that each film thickness became 20 µm, and they were dried at 80°C for 1 hour. Folding properties and adhesion of the obtained double-layer sheets were evaluated. The results are shown in Table 1.

On the fluorine coating material-applied surface of each double-layer sheet, an EVA sheet having a thickness of 100 µm was laminated, and they were compressed under a load of 100 g/cm² at 150°C. The evaluation results of adhesion between the fluororesin layer and the EVA layer are shown in Table 1.

### EXAMPLE 1

On one surface of PET film having a thickness of 50 µm, the coating material composition (D7-a) was applied so that the film thickness became 20 µm, and it was dried at 80°C for 1 hour. Folding properties of the obtained double-layer sheet were evaluated by methods of folding property evaluation 1 and folding property evaluation 2, and both results were O. With regard to adhesion, 100 squares of the 100 squares formed by cutting were separated.

On the fluorine-coating material-applied surface of the double layer sheet, an EVA sheet having a thickness of 100 µm was laminated, and they were compressed under a load of 100 g/cm² at 150°C. The adhesion between the fluororesin layer and the EVA layer was evaluated, but 100 squares of the 100 squares were not separated.

### EXAMPLE 2

Application and evaluations were carried out in the same manner as in Example 1 except that (D7-b) was used as the coating material composition. The folding properties of the double-layer sheet were evaluated by the methods of folding property evaluation 1 and folding property evaluation 2, and both results were O. With regard to adhesion, 45 squares of the 100 squares formed by cutting were separated. The adhesion between the fluororesin layer and the EVA layer was evaluated, and 100 squares of the 100 squares were not separated.

### EXAMPLE 3

Application and evaluations were carried out in the same manner as in Example 1 except that (D8) was used as the coating material composition. The folding properties of the double-layer sheet were evaluated by the methods of folding property evaluation 1 and folding property evaluation 2, and both results were □. With regard to adhesion, 3 squares of the 100 squares formed by cutting were separated. The adhesion between the fluororesin layer and the EVA layer was evaluated, and 100 squares of the 100 squares were not separated.

### [Evaluation methods]

Folding property evaluation 1: A double-layer structure sheet is folded to make an angle of 180° along a cylindrical mandrel having a diameter of 2 mm so that the applied surface faces outward, and fracturing of the coating film is observed. □ means a state of no fracture, and × means a state of fracturing.

Folding property evaluation 2: A double-layer structure sheet is folded so that the coating surface faces outward, and then it is left for 1 minute with a load of 50 g/cm² applied. Then the load is removed and the fracturing of the coating film is observed. □ represents a state of no fracture, and × represents a state of fracturing.

Adhesion evaluation: 100 squares having a width of 1 mm are cut in a coating film and a piece of cellophane tape is taped thereon, and the cellophane tape is removed to evaluate the adhesion of the coating film to the base. □ represents at least 91 squares adhered, □ represents from 90 to 51 squares adhered, and × represents from 50 to 0 square adhered.

**TABLE 1**

| Coating material composition | D1 | D1-a | D1-b | D2 | D3 | D4 | D5 | D6 | D7-a | D7-b | D7-c | D8 | D8-b |
|---|---|---|---|---|---|---|---|---|---|---|---|---|---|
| Folding property evaluation 1 | □ | □ | □ | □ | □ | □ | □ | □ | □ | □ | □ | □ | □ |
| Folding property evaluation 2 | □ | □ | □ | □ | □ | □ | □ | □ | □ | □ | □ | □ | □ |
| Adhesion (PET/fluororesin) | □ | □ | □ | □ | □ | □ | □ | □ | × | □ | × | □ | □ |
| Adhesion (EVA/fluororesin) | □ | □ | □ | □ | □ | □ | □ | □ | □ | □ | □ | □ | □ |

### [Solar cell module 1]

On one surface of PET films having a thickness of 50 µm, via a polyester adhesive, coating material compositions (D1), (D1-a), (D1-b), (D2), (D3), (D4), (D5), (D6), (D7-a), (D7-b), (D7-c), (D8) and (D8-b) respectively are applied so that the film thickness becomes 20 µm, and dried at 80°C for 1 hour. On the side opposite to the coating film of each PET film, an EVA sheet having a thickness of 100 µm is laminated via a polyester adhesive, and they are compressed under a load of 100 g/cm² at 150°C to prepare a backsheet. At the EVA side of this backsheet, a solar cell module having a structure wherein a solar cell, an EVA sheet and a glass plate are stacked is prepared.

### [Solar cell module 2]

On one surface of PET films having a thickness of 50 µm, via a polyester adhesive, coating material compositions (D1), (D1-a), (D1-b), (D2), (D3), (D4), (D5), (D6), (D7-a), (D7-b), (D7-c), (D8) and (D8-b) respectively are applied so that the film thickness becomes 20 µm, and dried at 80°C for 1 hour. Next, on the side of each PET film wherein a coating film is applied, an EVA sheet having a thickness of 100 µm is laminated via a polyester adhesive, and they are compressed under a load of 100 g/cm² at 150°C to prepare a backsheet. At the EVA side of this backsheet, a solar cell module having a structure wherein a solar cell, an EVA sheet and a glass plate are stacked is prepared.

The present invention provides a light weight and high productive backsheet for a solar cell module, wherein a cured coating film layer of a fluoropolymer coating material formed on one side or each side of a substrate sheet is free from problems such as cracking, fracturing, whitening and separation.

### EXPLANATION OF LETTERS OR NUMERALS

- 1:: Solar cell
- 2:: Sealing material layer
- 3:: Surface layer
- 4:: Substrate sheet
- 5:: Cured coating film layer
- 6:: Metal layer
- 7:: Another polymer layer (for example, an EVA layer)

## Claims

1. A backsheet for a solar cell module, comprising a substrate sheet and a cured coating film layer of a coating material formed on one side or each side of the substrate sheet, said coating material is an aqueous dispersion coating material comprising water and a fluoropolymer (A) obtained by solution polymerization dispersed in water, said fluoropolymer (A) having repeating units based on a fluoroolefin (a), repeating units based on a crosslinkable group-containing monomer (b) having a hydroxy group as the crosslinkable group, and repeating units based on an alkyl group-containing monomer (c) wherein a C₂₋₂₀ linear or branched alkyl group having no quaternary carbon atom, and a polymerizable unsaturated group are linked to each other by an ether bond or ester bond, wherein the fluoropolymer (A) is a fluoropolymer having carboxy groups and of which some or all of the carboxy groups constitute salts with a basic substance.

2. The backsheet for a solar cell module according to Claim 1, wherein the total content of the repeating units based on the alkyl group-containing monomer (c) in the all repeating units in the fluoropolymer (A) is from 10 to 50 mol%.

3. The backsheet for a solar cell module according to Claim 1 or 2, wherein the crosslinkable group of the crosslinkable group-containing monomer (b) is a hydroxy group, and the fluoropolymer (A) has a hydroxy value of from 30 to 200 mgKOH/g.

4. The backsheet for a solar cell module according to any one of Claims 1 to 3, wherein the coating material is an aqueous dispersion coating material, wherein the fluoropolymer (A) having a hydroxy group at the terminal as a crosslinkable group and a side chain having a polyoxyethylene structure, is dispersed in water.

5. The backsheet for a solar cell module according to any one of Claims 1 to 4, wherein the coating material contains an ultraviolet absorbing agent.

6. The backsheet for a solar cell module according to any one of Claims 1 to 5, wherein the coating material contains a pigment.

7. The backsheet for a solar cell module according to Claim 6, wherein the pigment is titanium oxide or the following composite particles:
Composite particles: Particles comprising particles containing titanium oxide, a covering layer covering the above particles and made of a layer containing cerium oxide, and a covering layer covering the above coating film layer and made of a layer containing silicon oxide.

8. The backsheet for a solar cell module according to any one of Claims 1 to 7, wherein a layer of a polymer material different from the above cured coating film layer is formed on the outermost surface of the backsheet at the side in contact with the solar cell.

9. A solar cell module having a surface sheet, a sealing layer in which a solar cell is sealed with a resin and the backsheet for a solar cell module as defined in any one of Claims 1 to 8, laminated in this order.

10. A process for producing a backsheet for a solar cell module, comprising acid-modifying, with an acid anhydride, some or all of the hydroxy groups of a fluoropolymer having repeating units based on a fluoroolefin (a), repeating units based on a crosslinkable group-containing monomer (b) having a hydroxy group as the crosslinkable group and repeating units based on an alkyl group-containing monomer (c) wherein a C₂₋₂₀ linear or branched alkyl group having no quaternary carbon atom, and a polymerizable unsaturated group are linked to each other by an ether bond or ester bond; neutralizing it with a base substance to obtain a fluoropolymer (A) obtained by solution polymerization; and applying an aqueous dispersion coating material comprising the fluoropolymer (A), water and a curing agent, to one side or each side of a substrate sheet, followed by drying and curing to form a cured coating film layer.

11. The production process according to Claim 10, wherein the curing agent is an aqueous dispersible isocyanate curing agent.

## Patentansprüche

1. Rückseitenfolie für ein Solarzellenmodul, umfassend eine Substratfolie und eine ausgehärtete Beschichtungsfilm-Schicht eines Beschichtungsmaterials, ausgebildet auf einer Seite oder auf jeder Seite der Substratfolie, das Beschichtungsmaterial ist ein wässriges Dispersionsbeschichtungsmaterial, umfassend Wasser und ein durch Lösungspolymerisation erhaltenes Fluorpolymer (A), das in Wasser feinstverteilt ist, das Fluorpolymer (A) weist wiederkehrende Einheiten basierend auf einem Fluorolefin (a), wiederkehrende Einheiten basierend auf einem eine vernetzbare Gruppe enthaltenden Monomer (b) mit einer Hydroxygruppe als vernetzbare Gruppe und wiederkehrende Einheiten basierend auf einem eine Alkylgruppe enthaltenden Monomer (c) auf, wobei eine geradkettige oder verzweigte C₂₋₂₀-Alkylgruppe mit keinem quaternären Kohlenstoffatom und eine polymerisierbare, ungesättigte Gruppe durch eine Etherbindung oder eine Esterbindung miteinander verbunden sind, wobei das Fluorpolymer (A) ein Fluorpolymer mit Carboxygruppen ist, und von welchem einige oder alle Carboxygruppen Salze mit einer basischen Substanz bilden.

2. Rückseitenfolie für ein Solarzellenmodul nach Anspruch 1, wobei der Gesamtanteil der wiederkehrenden Einheiten basierend auf dem eine Alkylgruppe enthaltenden Monomer (c) von allen wiederkehrenden Einheiten in dem Fluorpolymer (A) 10 bis 50 mol% beträgt.

3. Rückseitenfolie für ein Solarzellenmodul nach Anspruch 1 oder 2, wobei die vernetzbare Gruppe des eine vernetzbare Gruppe enthaltenden Monomers (b) eine Hydroxygruppe ist und das Fluorpolymer (A) eine Hydroxylzahl von 30 bis 200 mgKOH/g aufweist.

4. Rückseitenfolie für ein Solarzellenmodul nach einem der Ansprüche 1 bis 3, wobei das Beschichtungsmaterial ein wässriges Dispersionsbeschichtungsmaterial ist, wobei das Fluorpolymer (A) mit einer Hydroxygruppe am Ende als vernetzbare Gruppe und einer Seitenkette mit einer Polyoxyethylen-Struktur in Wasser feinstverteilt ist.

5. Rückseitenfolie für ein Solarzellenmodul nach einem der Ansprüche 1 bis 4, wobei das Beschichtungsmaterial ein Ultraviolett-Absorptionsmittel enthält.

6. Rückseitenfolie für ein Solarzellenmodul nach einem der Ansprüche 1 bis 5, wobei das Beschichtungsmaterial ein Pigment enthält.

7. Rückseitenfolie für ein Solarzellenmodul nach Anspruch 6, wobei das Pigment Titanoxid oder die folgenden Verbundteilchen ist:
Verbundteilchen: Teilchen, umfassend Titanoxid enthaltende Teilchen, eine Deckschicht, die die obigen Teilchen bedeckt und aus einer Ceroxid-haltigen Schicht hergestellt ist, und eine Deckschicht, die die obige Beschichtungsfilm-Schicht bedeckt und aus einer Siliziumoxid-haltigen Schicht hergestellt ist.

8. Rückseitenfolie für ein Solarzellenmodul nach einem der Ansprüche 1 bis 7, wobei eine Schicht eines Polymermaterials, verschieden von der obigen ausgehärteten Beschichtungsfilm-Schicht, auf der äußersten Oberfläche der Rückseitenfolie an der Seite in Kontakt mit der Solarzelle ausgebildet ist.

9. Solarzellenmodul mit einer Oberflächenschicht, einer Versiegelungsschicht, in welcher eine Solarzelle mit einem Harz versiegelt ist, und die Rückseitenfolie für ein Solarzellenmodul, wie in einem der Ansprüche 1 bis 8 definiert, laminiert in dieser Reihenfolge.

10. Verfahren zur Herstellung einer Rückseitenfolie für ein Solarzellenmodul, umfassend das Säuremodifizieren einiger oder aller Hydroxygruppen eines Fluorpolymers mit einem Säureanhydrid, das wiederkehrende Einheiten basierend auf einem Fluorolefin (a), wiederkehrende Einheiten basierend auf einem eine vernetzbare Gruppe enthaltenden Monomer (b) mit einer Hydroxygruppe als vernetzbare Gruppe und wiederkehrende Einheiten basierend auf einem eine Alkylgruppe enthaltenden Monomer (c) aufweist, wobei eine geradkettige oder verzweigte C₂₋₂₀-Alkylgruppe mit keinem quaternären Kohlenstoffatom und eine polymerisierbare, ungesättigte Gruppe durch eine Etherbindung oder eine Esterbindung miteinander verbunden sind; das Neutralisieren derselben mit einer basischen Substanz, um ein durch Lösungspolymerisation erhaltenes Fluorpolymer (A) zu erhalten; und das Auftragen eines wässrigen Dispersionsbeschichtungsmaterials, umfassend das Fluorpolymer (A), Wasser und ein Härtemittel, auf einer Seite oder auf jeder Seite einer Substratfolie, gefolgt vom Trocknen und Härten, um eine ausgehärtete Beschichtungsfilm-Schicht zu bilden.

11. Herstellungsverfahren nach Anspruch 10, wobei das Härtemittel ein wässriges, dispergierbares Isocyanat-Härtemittel ist.

## Revendications

1. Feuille d'envers pour un module de cellule solaire, comprenant une feuille de substrat et une couche de film de revêtement durcie constituée d'un matériau de revêtement formé sur un côté ou chaque côté de la feuille de substrat, ledit matériau de revêtement étant un matériau de revêtement en dispersion aqueuse comprenant de l'eau et un polymère fluoré (A) obtenu par polymérisation en suspension dispersé dans l'eau, ledit polymère fluoré (A) présentant des motifs répétitifs à base d'une oléfine fluorée (a), des motifs répétitifs à base d'un monomère contenant un groupe réticulable (b) comportant un groupe hydroxy en tant que groupe réticulable, et des motifs répétitifs à base d'un monomère comportant un groupe alkyle (c) dans lequel un groupe alkyle en C₂ à C₂₀ linéaire ou ramifié ne comportant pas d'atome de carbone quaternaire et un groupe insaturé polymérisable sont liés l'un à l'autre par une liaison éther ou une liaison ester, dans laquelle le polymère fluoré (A) est un polymère fluoré comportant des groupes carboxy et dont tout ou partie des groupes carboxy constituent des sels avec une substance basique.

2. Feuille d'envers pour un module de cellule solaire selon la revendication 1, dans laquelle la teneur totale en les motifs répétitifs à base du monomère comportant un groupe alkyle (c) parmi tous les motifs répétitifs dans le polymère fluoré (A) est de 10 à 50 % en moles.

3. Feuille d'envers pour un module de cellule solaire selon la revendication 1 ou 2, dans laquelle le groupe réticulable du monomère comportant un groupe réticulable (b) est un groupe hydroxy, et le polymère fluoré (A) présente un indice d'hydroxyle de 30 à 200 mg KOH/g.

4. Feuille d'envers pour un module de cellule solaire selon l'une quelconque des revendications 1 à 3, dans laquelle le matériau de revêtement est un matériau de revêtement en dispersion aqueuse, et dans laquelle le polymère fluoré (A), comportant un groupe hydroxy à l'extrémité en tant que groupe réticulable et une chaîne latérale présentant une structure de polyoxyéthylène, est dispersé dans l'eau.

5. Feuille d'envers pour un module de cellule solaire selon l'une quelconque des revendications 1 à 4, dans laquelle le matériau de revêtement contient un agent absorbant les ultraviolets.

6. Feuille d'envers pour un module de cellule solaire selon l'une quelconque des revendications 1 à 5, dans laquelle le matériau de revêtement contient un pigment.

7. Feuille d'envers pour un module de cellule solaire selon la revendication 6, dans laquelle le pigment est l'oxyde de titane ou les particules composites suivantes :
particules composites : particules comprenant des particules contenant de l'oxyde de titane, une couche d'enrobage enrobant les particules ci-dessus et faite d'une couche contenant de l'oxyde de cérium, et une couche d'enrobage enrobant la couche de film de revêtement ci-dessus et faite d'une couche contenant de l'oxyde de silicium.

8. Feuille d'envers pour un module de cellule solaire selon l'une quelconque des revendications 1 à 7, dans laquelle une couche d'un matériau polymère différente de la couche de film de revêtement durcie ci-dessus est formée sur la couche la plus extérieure de la feuille d'envers du côté en contact avec la cellule solaire.

9. Module de cellule solaire ayant une feuille de surface, une couche de scellement dans laquelle une cellule solaire est scellée avec une résine et la feuille d'envers pour un module de cellule solaire telle que définie dans l'une quelconque des revendications 1 à 8, stratifiées dans cet ordre.

10. Procédé pour produire une feuille d'envers pour un module de cellule solaire, comprenant la modification acide, avec un anhydride d'acide, de tout ou partie des groupes hydroxy d'un polymère fluoré présentant des motifs répétitifs à base d'une oléfine fluorée (a), des motifs répétitifs à base d'un monomère comportant un groupe réticulable (b) comportant un groupe hydroxy en tant que groupe réticulable, et des motifs répétitifs à base d'un monomère comportant un groupe alkyle (c) dans lequel un groupe alkyle en C₂ à C₂₀ linéaire ou ramifié ne comportant pas d'atome de carbone quaternaire et un groupe insaturé polymérisable sont liés l'un à l'autre par une liaison éther ou une liaison ester ; leur neutralisation avec une substance basique pour donner un polymère fluoré (A) obtenu par polymérisation en solution ; et l'application d'un matériau de revêtement en dispersion aqueuse comprenant le polymère fluoré (A), de l'eau et un agent durcisseur, sur un côté ou chaque côté d'une feuille de substrat, suivie d'un séchage et d'un durcissement pour former une couche de film de revêtement durcie.

11. Procédé de production selon la revendication 10, dans lequel l'agent durcisseur est un agent durcisseur isocyanate dispersible en solution aqueuse.
